# EUROPEAN PATENT SPECIFICATION

(11) **EP 4 053 573 B1**
(45) Date of publication and mention of the grant of the patent: **10.12.2025**
(21) Application number: 21814470.7
(22) Date of filing: 19.04.2021
(51) Int. Cl.: G01R 31/392, H01M 10/48, H01M 10/42, H01M 10/052

(54) **BATTERY MANAGEMENT SYSTEM, BATTERY PACK, ELECTRIC VEHICLE AND BATTERY MANAGEMENT METHOD**
BATTERIEVERWALTUNGSSYSTEM, BATTERIEPACK, ELEKTRISCHES FAHRZEUG UND BATTERIEVERWALTUNGSVERFAHREN
SYSTÈME DE GESTION DE BATTERIE, BLOC-BATTERIE, VÉHICULE ÉLECTRIQUE ET PROCÉDÉ DE GESTION DE BATTERIE

(30) Priority: 27.05.2020 KR 20200063839
(43) Date of publication of application: 07.09.2022
(73) Proprietor: LG Energy Solution, Ltd., Seoul 07335 (KR)
(72) Inventor: CHOI, Hyun-Jun, Daejeon 34122 (KR); KIM, Young-Deok, Daejeon 34122 (KR); KIM, Dae-Soo, Daejeon 34122 (KR); JEE, Su-Won, Daejeon 34122 (KR)
(74) Representative: Plasseraud IP
(86) International application number: PCT/KR2021/004902
(87) International publication number: WO 2021/241886

(56) References cited:
- WO-A1-2013/157132
- WO-A1-2020/033343
- CN-A- 110 045 293
- KR-A- 20100 068 459
- KR-A- 20160 064 881
- KR-A- 20200 026 128
- KR-B1- 102 010 015
- US-A1- 2013 314 050

## Description

### TECHNICAL FIELD

The present disclosure relates to technology for battery degradation diagnosis.

### BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be charged and discharged repeatedly.

Currently, commercially available batteries include nickel-cadmium batteries, nickel-hydrogen batteries, nickel-zinc batteries, lithium batteries and the like, and among them, lithium ion batteries have little or no memory effect, and thus they are gaining more attention than nickel-based batteries for their advantages that recharging can be done whenever it is convenient, the self-discharge rate is very low and the energy density is high.

There are a variety of technologies for monitoring the degradation of the battery. In particular, Differential Voltage Analysis (DVA) is used to determine the inside degradation state of the battery based on the voltage and the current which are observable parameters outside of the battery.

In checking the internal state of the battery using DVA, peaks in a differential voltage curve ('Q-dV/dQ curve') are considered as major factors.

When the battery is at Beginning Of Life (BOL), all peaks in the differential voltage curve may be classified into peak(s) dependent on the characteristics of the positive electrode of the battery and peak(s) dependent on the characteristics of the negative electrode of the battery.

However, as the battery gradually degrades, there is the growing overlap in the capacity ranges in which the peaks appearing in the differential voltage curve. For example, as the battery degrades, there may be a reduction in a capacity difference between the first peak among the peaks dependent on the characteristics of the positive electrode and the second peak among the peaks dependent on the characteristics of the negative electrode. As such, when the peak dependent on the positive electrode and the peak dependent on the negative electrode appear together in a narrow capacity range, it is difficult to accurately determine degradation information of the battery from the two peaks.

KR2020 0026128 relates to a battery management device that comprises a sensing unit for generating battery information and a control unit. The control unit determines a differential voltage curve on the basis of a history of the battery information during a sensing period where a battery is charged with current of a first current rate. The control unit detects a plurality of feature points from the differential voltage curve. The control unit determines whether stabilization for an electrode material of the battery is necessary based on a feature value of each of the feature points. The control unit outputs a control signal for inducing the battery to be discharged with current of a second current rate when it is determined that the stabilization for an electrode material of the battery is necessary. The second current rate is smaller than the first current rate.

WO2013/157132 relates to a secondary battery system that comprises: a secondary battery; a charge/discharge control unit; a derivative curve computation unit which computes a derivative curve (Q-dV/dQ); a degradation state operation unit which operates a parameter of a feature point in the derivative curve (Q-dV/dQ); and a battery state sensing unit which determines the degradation state of the secondary battery. The degradation state operation unit operates as the parameter of the feature point a difference (sigmai) of a battery capacity (Q1) at a first feature point of the derivative curve (Q-dV/dQ) in a prescribed state sensing range and a battery capacity (Q2) at a second feature point thereof, and/or a difference (hi) of a derivative value (dV1/dQ1) at the first feature point and a derivative value (dV2/dQ2) at the second feature point. Based on a result of a comparison of the difference (sigmai) and a pre-stored initial value (sigma0) of the difference (sigmai) and/or a result of a comparison between the difference (hi) and a pre-stored initial value (h0) of the difference (hi), the battery state sensing unit determines the degradation state of the secondary battery.

CN 110 045 293 relates to a method for non-destructive analysis of a battery active material failure that comprises the following steps that firstly, capacity voltage differential curve characteristic peaks of a positive electrode and a negative electrode are separately collected by using a three-electrode battery; and secondly, the characteristic peaks separately representing the positive electrode and the negative electrode in the whole battery are identified through superposition of the characteristic peaks of the positive electrode and the negative electrode in the whole battery, and a characteristic peak database of the battery is established; and then through the change of the characteristic peaks of the positive electrode and the negative electrode in the capacity-voltage differential curve of the failed battery, the attenuation of the active substance can be determined through analysis and judgment.

WO20200033343 relates to an electrical device including a battery cell, a voltage sensor operatively coupled to the battery cell in order to measure a voltage level of the battery cell, a current sensor operatively coupled to the battery cell in order to measure an amount of current drawn from or supplied to the battery cell, and a battery management system (BMS). The battery management system includes a controller In communication with the voltage sensor and the current sensor. The controller is configured to execute a program stored in the BMS to calculate a state of health of the individual battery electrodes comprising a battery cell using a first differential voltage point, a second differential voltage point, and a characteristic curve of a fresh battery electrode of a fresh battery cell, wherein the battery cell includes a second battery electrode not exhibiting distinct phase transitions during a charge-discharge cycle.

### DISCLOSURE

### Technical Problem

The present disclosure is designed to solve the above-described problem, and therefore the present disclosure is directed to providing a battery management system and a battery management method in which degradation information of a battery is determined using a differential voltage curve obtained through constant current charging or constant current discharging of the battery including a positive electrode material exhibiting a phase transition behavior in a predetermined capacity range and a negative electrode material having plateau characteristics over the predetermined capacity range.

These and other objects and advantages of the present disclosure may be understood by the following description and will be apparent from the embodiments of the present disclosure. In addition, it will be readily understood that the objects and advantages of the present disclosure may be realized by the means set forth in the appended claims and a combination thereof.

### Technical Solution

A battery management system according to claim 1 is provided in an aspect of the present disclosure

The sensing unit may include a voltage sensor connected in parallel to the battery, and a current sensor connected in series to the battery.

The control unit may be configured to determine the second capacity loss ratio of the battery based on a second difference when the differential voltage of the peak of interest is equal to the reference differential voltage. The second difference is a difference between the capacity of the peak of interest and a reference capacity.

The control unit may be configured to determine the first capacity loss ratio of the battery and a second capacity loss ratio indicating a loss ratio of usable lithium capacity of the battery based on a first difference and a second difference. The first difference is a difference between the differential voltage of the peak of interest and the reference differential voltage. The second difference is a difference between the capacity of the peak of interest and the reference capacity.

A battery pack according to another aspect of the present disclosure includes the battery management system.

An electric vehicle according to still another aspect of the present disclosure includes the battery pack.

A battery management method according to claim 7 is provided in yet another aspect of the present disclosure.

### Advantageous Effects

According to at least one of the embodiments of the present disclosure, it is possible to determine degradation information of a battery using a differential voltage curve obtained through constant current charging or constant current discharging of the battery including a positive electrode material exhibiting a phase transition behavior in a predetermined capacity range and a negative electrode material having plateau characteristics over the predetermined capacity range.

The effects of the present disclosure are not limited to the effects mentioned above, and these and other effects will be clearly understood by those skilled in the art from the appended claims.

### BRIEF DESCRIPTION OF THE DRAWINGS

The accompanying drawings illustrate a preferred embodiment of the present disclosure, and together with the detailed description of the present disclosure described below, serve to provide a further understanding of the technical aspects of the present disclosure, and thus the present disclosure should not be construed as being limited to the drawings.
FIG. 1 is a diagram exemplarily showing a configuration of an electric vehicle according to the present disclosure.
FIG. 2 is a graph exemplarily showing a voltage curve as a function of degradation state of a battery.
FIG. 3 is a graph exemplarily showing a differential voltage curve corresponding to the voltage curve of FIG. 2.
FIG. 4 is a flowchart exemplarily showing a battery management method according to a first embodiment of the present disclosure.
FIG. 5 is a flowchart exemplarily showing a battery management method according to a second embodiment of the present disclosure.

### DETAILED DESCRIPTION

Hereinafter, the preferred embodiments of the present disclosure will be described in detail with reference to the accompanying drawings.

The embodiments described herein and illustrations shown in the drawings are just a most preferred embodiment of the present disclosure, but not intended to fully describe the technical aspects of the present disclosure, so it should be understood that a variety of other equivalents and modifications could have been made thereto at the time that the application was filed. The scope of the invention is defined by the appended claims.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and this may be implemented by hardware and software either alone or in combination.

In addition, throughout the specification, it will be further understood that when an element is referred to as being "connected to" another element, it can be directly connected to the other element or intervening elements may be present.

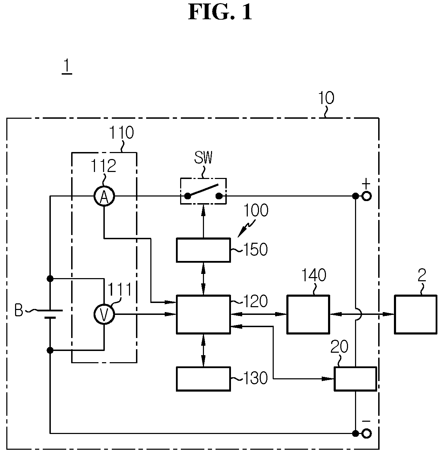

FIG. 1 is a diagram exemplarily showing a configuration of an electric vehicle according to the present disclosure.

Referring to FIG. 1, a battery pack 10 is provided to be mounted on an electricity powered device such as the electric vehicle 1, and includes a battery B, a switch SW, a charge/discharge device 20 and a battery management system 100.

A positive electrode terminal and a negative electrode terminal of the battery B are electrically connected to the battery management system 100. The battery B is a lithium ion battery, and includes a positive electrode, a negative electrode and a separator. The separator is interposed between the positive electrode and the negative electrode to insulate the positive electrode from the negative electrode.

A positive electrode material may include a positive electrode active material exhibiting a phase transition behavior in a predetermined capacity range during the charge/discharge of the battery B. The positive electrode material may have a layered crystal structure. For example, the positive electrode active material may include lithium metal composite oxide such as LiNi_{8/10}Co_{1/10}Mn_{1/10}O₂. The phase transition at the positive electrode may be a phenomenon that occurs due to the movement of an operating ion (for example, a lithium ion) through a channel in the layered crystal structure of the positive electrode material during the charge/discharge of the battery B.

A negative electrode material may include a negative electrode active material having plateau characteristics over the predetermined capacity range. The plateau characteristics are characteristics showing a change in potential kept less than a predetermined value without phase transition. For example, the negative electrode active material may include a carbon based material (for example, graphite).

The switch SW is installed on a current path connected in series to the battery B for the charge/discharge of the battery B. While the switch SW is turned on, the battery B can be charged/discharged. The switch SW may be a mechanical relay that is turned on/off by the electromagnetic force of a coil or a semiconductor switch such as a Metal Oxide Semiconductor Field Effect transistor (MOSFET). While the switch SW is turned off, the charge/discharge of the battery B is stopped. The switch SW may be turned on in response to a first switching signal (for example, a high level voltage). The switch SW may be turned off in response to a second switching signal (for example, a low level voltage).

The charge/discharge device 20 is electrically connected to the current path for the charge/discharge of the battery B. The charge/discharge device 20 may include a constant current circuit to adjust the current rate of the electric current flowing through the battery B. The charge/discharge device 20 is configured to adjust the current rate (referred to as 'C-rate') of the electric current for the charge or discharge of the battery B according to a command from the battery management system 100. Of course, the charge/discharge device 20 may perform only one of the constant current charging function and the constant current discharging function.

The battery management system 100 is provided to determine the degradation state of the battery B. The battery management system 100 includes a sensing unit 110, a control unit 120 and a memory unit 130. The battery management system 100 may further include an interface unit 140. The battery management system 100 may further include a switch driver 150.

The sensing unit 110 includes a voltage sensor 111 and a current sensor 112. The voltage sensor 111 is connected in parallel to the battery B, and is configured to detect the voltage across the battery B and generate a voltage signal indicating the detected voltage. The current sensor 112 is connected in series to the battery B through the current path. The current sensor 112 is configured to detect the electric current flowing through the battery B and generate a current signal indicating the detected electric current. The control unit 120 may collect sensing information including the voltage signal and the current signal in synchronization from the sensing unit 110.

The control unit 120 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The control unit 120 is operably coupled to the charge/discharge device 20 and the sensing unit 110. The control unit 120 is configured to perform an operation for determining the degradation state of the battery B as described below. In case that the capacity of the battery B is equal to or larger than a first threshold capacity, the control unit 120 may command the constant current charging to the charge device 20. The charge device 20 may maintain the constant current charging at a predetermined current rate (for example, 0.05C) until the capacity of the battery B rises to a second threshold capacity. When the capacity of the battery B is equal to or larger than the second threshold capacity, the control unit 120 may command the constant current discharging to the charge device 20. The charge device 20 may maintain the constant current discharging at the predetermined current rate (for example, 0.05C) until the capacity of the battery B drops down to the first threshold capacity. For example, the first threshold capacity may correspond to SOC 0%, and the second threshold capacity may correspond to SOC 100%.

The control unit 120 is configured to determine the voltage, the current, the capacity and the State-Of-Charge (SOC) of the battery B at a predetermined time interval based on the voltage signal and the current signal included in the sensing information at the predetermined time interval during the constant current charging or constant current discharging of the battery B.

The capacity of the battery B indicates an amount of charges stored in the battery B and may be referred to as 'remaining capacity', and may be determined by accumulating the current of the battery B at the predetermined time interval. The SOC of the battery B indicates a ratio of the capacity of the battery B to the maximum capacity (also known as 'full charge capacity') of the battery B, and is generally expressed in 0~1 or 0~100%. The maximum capacity of the battery B gradually decreases as the battery B degrades. At least one of the voltage, the current, the capacity or the SOC at the predetermined time interval may be recorded in the memory unit 130 by the control unit 120.

The memory unit 130 is operably coupled to the control unit 120. The memory unit 130 may be also operably coupled to the sensing unit 110. The memory unit 130 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM).

The memory unit 130 may store data and programs required for the computation operation by the control unit 120. The memory unit 130 may store data indicating the result of the computation operation by the control unit 120.

The interface unit 140 is configured to support wired communication or wireless communication between the control unit 120 and a high level controller 2 (for example, an Electronic Control Unit (ECU)) of the electric vehicle 1. The wired communication may be, for example, controller area network (CAN) communication, and the wireless communication may be, for example, Zigbee or Bluetooth communication. The communication protocol is not limited to a particular type, and may include any communication protocol which supports wired/wireless communication between the control unit 120 and the high level controller 2. The interface unit 140 may include an output device (for example, a display, a speaker) to provide information received from the control unit 120 and/or the high level controller 2 in a recognizable format.

The switch driver 150 is electrically coupled to the control unit 120 and the switch SW. The switch driver 150 is configured to selectively output the first switching signal or the second switching signal to the switch SW in response to the command from the control unit 120. The control unit 120 may command the switch driver 150 to turn on the switch SW during the constant current charging or constant current discharging of the battery Bs.

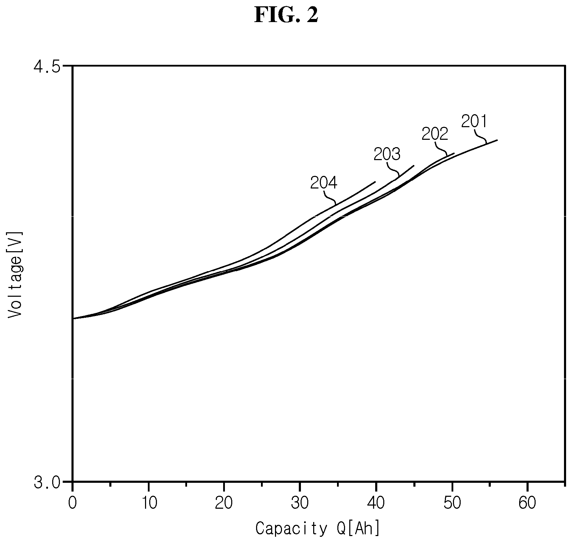

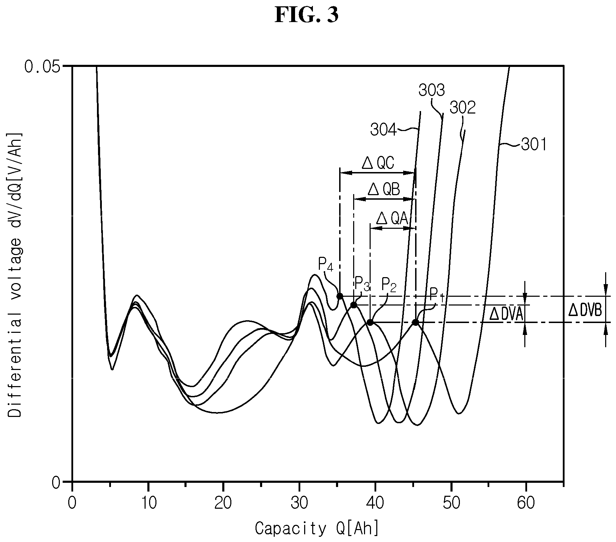

FIG. 2 is a graph exemplarily showing a voltage curve as a function of the degradation state of the battery, and FIG. 3 is a graph exemplarily showing a differential voltage curve corresponding to the voltage curve of FIG. 2.

In the specification, a first capacity loss ratio is a parameter corresponding to the degree of degradation of the positive electrode of the battery B, and indicates how much the current positive electrode capacity of the battery B is reduced from a reference positive electrode capacity which is the positive electrode capacity of the battery B at BOL. The positive electrode capacity indicates the total amount of lithium ions that can be intercalated into the positive electrode to the maximum extent. As the reaction area of the positive electrode decreases, the first capacity loss ratio increases. That is, first capacity loss ratio = (reference positive electrode capacity - current positive electrode capacity)/reference positive electrode capacity.

In the specification, a second capacity loss ratio indicates how much the current usable lithium capacity of the battery B is reduced from a reference usable lithium capacity which is a usable lithium capacity of the battery B at BOL. The usable lithium capacity indicates the total amount of lithium ions that can participate in the oxidation/reduction reaction during charging/discharging. As the amount of lithium metal deposited on the surface of the negative electrode increases, the second capacity loss ratio increases. That is, second capacity loss ratio = (reference usable lithium capacity - current usable lithium capacity)/reference usable lithium capacity.

Referring to FIGS. 1 and 2, the control unit 120 may generate a voltage curve based on the voltage and the capacity of the battery B at the predetermined time interval recorded in the memory unit 130 during the constant current charging or constant current discharging of the battery B.

FIG. 2 shows four voltage curves 201∼204. The voltage curve 201 indicates a relationship between the capacity Q and the voltage V of the battery B at BOL. The voltage curve 202 indicates a relationship between the capacity Q and the voltage V of the battery B having the first capacity loss ratio of 0% and the second capacity loss ratio of 10%. The voltage curve 203 indicates a relationship between the capacity Q and the voltage V of the battery B having the first capacity loss ratio of 5% and the second capacity loss ratio of 10%. The voltage curve 204 indicates a relationship between the capacity Q and the voltage V of the battery B having the first capacity loss ratio of 10% and the second capacity loss ratio of 10%.

It can be seen that when comparing the voltage curve 201 with the voltage curve 202, in case that the first capacity loss ratio is equal, as the second capacity loss ratio increases, the voltage of the voltage curve contracts to lower voltage, and the capacity of the voltage curve contracts to lower capacity.

It can be seen that when comparing the voltage curve 202, the voltage curve 203 and the voltage curve 204, in case that the capacity retention is equal, as the first capacity loss ratio increases, the voltage of the battery B changes rapidly. The capacity retention is a ratio of the current maximum capacity to the maximum capacity at BOL.

Referring to FIG. 3, the control unit 120 may determine differential voltage curves 301~304 by differentiation of the voltage V of each of the voltage curves 201∼204 into the capacity Q. The differential voltage curves 301~304 are based on the voltage curves 201∼204, respectively. The control unit 120 may determine a differential voltage dV/dQ which is a ratio of a change dV in the voltage V to a change dQ in the capacity Q at the predetermined time interval based on the voltage curves 201∼204, and record the differential voltage curves 301~304 as a dataset indicating a correspondence relationship between the capacity Q and the differential voltage dV/dQ in the memory unit 130. The differential voltage curve may be referred to as a 'Q-dV/dQ curve'.

The control unit 120 may detect peaks of interest P₁~_{P4} from the differential voltage curves 301~304, respectively. When i=1~4, the peak of interest Pᵢ of the differential voltage curve 30i may be a peak (for example, a maximum point) disposed alone in a predetermined capacity range (for example, 35~45 Ah). The peaks of interest P₁~P₄ result from the phase transition occurring in the positive electrode of the battery B.

When comparing the peak of interest P₁ with the peak of interest P₂, the differential voltage of the peak of interest P₂ is equal to the differential voltage of the peak of interest P₁, while the capacity of the peak of interest P₂ is smaller than the capacity of the peak of interest P₁. That is, it can be seen that in case that the first capacity loss ratio is equal, as the second capacity loss ratio increases, the capacity of the peak of interest tends to decrease.

When comparing the peak of interest P₂ with the peak of interest P₃, the differential voltage of the peak of interest P₃ is larger than the differential voltage of the peak of interest P₂. Additionally, when comparing the peak of interest P₃ with the peak of interest P₄, the differential voltage of the peak of interest P₄ is larger than the differential voltage of the peak of interest P₃. That is, it can be seen that in case that the capacity retention is equal, as the first capacity loss ratio increases, the differential voltage of the peak of interest tends to increase.

When comparing the peak of interest P₁ with the peak of interest P₄, the differential voltage of the peak of interest P₄ is larger than the differential voltage of the peak of interest P₁, and the capacity of the peak of interest P₄ is smaller than the capacity of the peak of interest P₁. That is, as the first capacity loss ratio increases, the differential voltage of the peak of interest tends to increase and the capacity of the peak of interest tends to decrease. Additionally, it can be seen that in case that as the first capacity loss ratio increases and the second capacity loss ratio increases as well, the capacity of the peak of interest tends to decrease much more.

The control unit 120 may determine a first difference based on the differential capacity curve. The first difference is a difference between the differential voltage of the peak of interest and a reference differential voltage. The reference differential voltage may be the differential voltage of the peak of interest P₁. Referring to FIG. 3, the first difference corresponding to the differential voltage curve 202 is 0 [V/Ah], the first difference corresponding to the differential voltage curve 203 is ΔDVA [V/Ah], and the first difference corresponding to the differential voltage curve 204 is ΔDVB [V/Ah].

The control unit 120 may determine a second difference based on the differential capacity curve. The second difference is a difference between the capacity of the peak of interest and a reference capacity. The reference capacity may be the capacity of the peak of interest P₁. Referring to FIG. 3, the second difference corresponding to the differential voltage curve 202 is ΔQA [Ah], the second difference corresponding to the differential voltage curve 203 is ΔQB [Ah], and the second difference corresponding to the differential voltage curve 204 is ΔQC [Ah].

In case that the differential voltage of the peak of interest detected from the differential capacity curve is larger than the reference differential voltage, the control unit 120 may determine the first capacity loss ratio of the battery B based on the first difference. For example, in case that the differential capacity curve 303 is determined through the constant current charging or constant current discharging of the battery B, the control unit 120 may determine the first capacity loss ratio of the battery B to be equal to 5% based on the first difference ΔDVA corresponding to the differential capacity curve 303.

In case that the differential voltage of the peak of interest is equal to the reference differential voltage, the control unit 120 may determine the second capacity loss ratio of the battery B based on the second difference. For example, in case that the differential capacity curve 302 is determined through the constant current charging or constant current discharging of the battery B, the control unit 120 may determine the second capacity loss ratio of the battery B to be equal to 10% based on the second difference ΔQA corresponding to the differential capacity curve 302.

In case that the differential voltage of the peak of interest detected from the differential capacity curve is larger than the reference differential voltage, the control unit 120 may determine the first capacity loss ratio and the second capacity loss ratio of the battery B based on the first difference and the second difference. For example, in case that the differential capacity curve 304 is determined through constant current charging or constant current discharging of the battery B, the control unit 120 may determine the first capacity loss ratio of the battery B to be equal to 10% and the second capacity loss ratio of the battery B to be equal to 10% based on the first difference ΔDVB and the second difference ΔQC corresponding to the differential capacity curve 304.

The memory unit 130 may pre-store at least one of a first lookup table, a second lookup table or a third lookup table.

The first lookup table is a dataset indicating a correspondence relationship between the first difference and the first capacity loss ratio. The correspondence relationship between the first difference and the first capacity loss ratio may be preset through experimentation or computer simulation. The control unit 120 may determine the first difference, and determine the first capacity loss ratio recorded in the first lookup table corresponding to the determined first difference.

The second lookup table is a dataset indicating a correspondence relationship between the second difference and the second capacity loss ratio. The correspondence relationship between the second difference and the second capacity loss ratio may be preset through experimentation or computer simulation. In case the differential voltage of the peak of interest is equal to the reference differential voltage, the control unit 120 may determine the second difference, and determine the second capacity loss ratio recorded in the second lookup table corresponding to the determined second difference.

The third lookup table is a dataset indicating a correspondence relationship between the first difference, the second difference, the first capacity loss ratio and the second capacity loss ratio. The correspondence relationship between the first difference, the second difference, the first capacity loss ratio and the second capacity loss ratio may be preset through experimentation or computer simulation. The control unit 120 may determine the first difference and the second difference, and determine the first capacity loss ratio and the second capacity loss ratio recorded in the third lookup table corresponding to the determined first difference and the determined second difference.

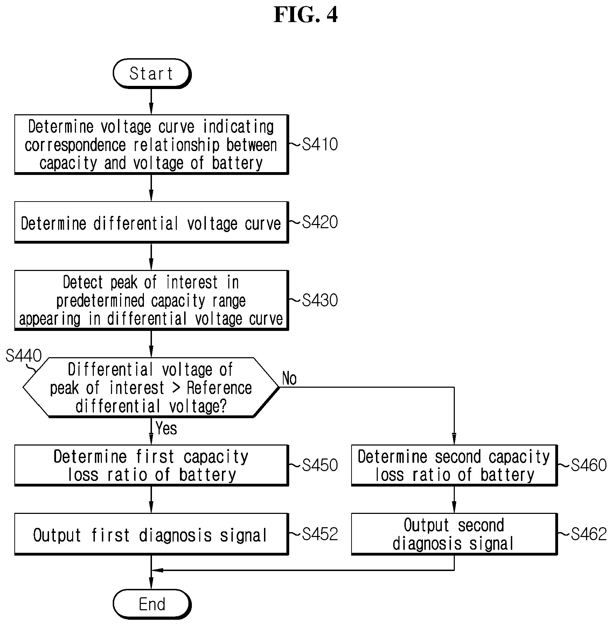

FIG. 4 is a flowchart exemplarily showing a battery management method according to a first embodiment of the present disclosure.

Referring to FIGS. 1 to 4, in step S410, the control unit 120 determines a voltage curve indicating a correspondence relationship between capacity Q and voltage V of the battery B based on sensing information indicating the voltage and the current of the battery collected from the sensing unit 110 at a predetermined time interval while the battery B is being charged or discharged at the constant current by the charge/discharge device 20.

In step S420, the control unit 120 determines a differential voltage curve based on the voltage curve determined in the step S410. For example, when the voltage curve 202 of FIG. 2 is determined in the step S410, the control unit 120 may determine the differential voltage curve 302 of FIG. 3 from the voltage curve 202. In another example, when the voltage curve 203 of FIG. 2 is determined in the step S410, the control unit 120 may determine the differential voltage curve 303 of FIG. 3 from the voltage curve 203.

In step S430, the control unit 120 detects a peak of interest in a predetermined capacity range appearing in the differential voltage curve determined in the step S420. For example, when the differential voltage curve 302 of FIG. 3 is determined in the step S420, the control unit 120 may detect the peak of interest P₂ from the differential voltage curve 302. In another example, when the differential voltage curve 303 of FIG. 3 is determined in the step S420, the control unit 120 may detect the peak of interest P₃ from the differential voltage curve 303.

In step S440, the control unit 120 determines whether the differential voltage of the peak of interest detected in the step S430 is larger than the reference differential voltage. In another example, when the differential voltage curve 303 of FIG. 3 is determined in the step S420, a value of the step S440 is "Yes". When the value of the step S440 is "Yes", step S450 is performed. The value of the step S440 being "No" indicates that the differential voltage of the peak of interest is equal to the reference differential voltage. In another example, when the differential voltage curve 302 of FIG. 3 is determined in the step S420, a value of the step S440 is "No". When the value of the step S440 is "No", step S460 may be performed.

In step S450, the control unit 120 determines a first capacity loss ratio of the battery B based on a first difference. The first difference is a difference between the differential voltage of the peak of interest detected in the step S430 and the reference differential voltage. For example, when the first difference is ΔDVA [V/Ah], 5% associated with ΔDVA [V/Ah] in the first lookup table may be determined as the first capacity loss ratio. The control unit 120 may record the first capacity loss ratio determined in the step S450 in the memory unit 130.

In step S452, the control unit 120 outputs a first diagnosis signal indicating the first capacity loss ratio determined in the step S450. The first diagnosis signal may be received by the interface unit 140. The interface unit 140 may transmit the first diagnosis signal to the high level controller 2.

In step S460, the control unit 120 determines a second capacity loss ratio of the battery B based on a second difference. The second difference is a difference between the capacity of the peak of interest detected in the step S430 and the reference capacity. For example, when the second difference is ΔQA [Ah], 10% associated with ΔQA [Ah] in the second lookup table may be determined as the second capacity loss ratio.

In step S462, the control unit 120 outputs a second diagnosis signal indicating the second capacity loss ratio determined in the step S460. The second diagnosis signal may be received by the interface unit 140. The interface unit 140 may transmit the second diagnosis signal to the high level controller 2.

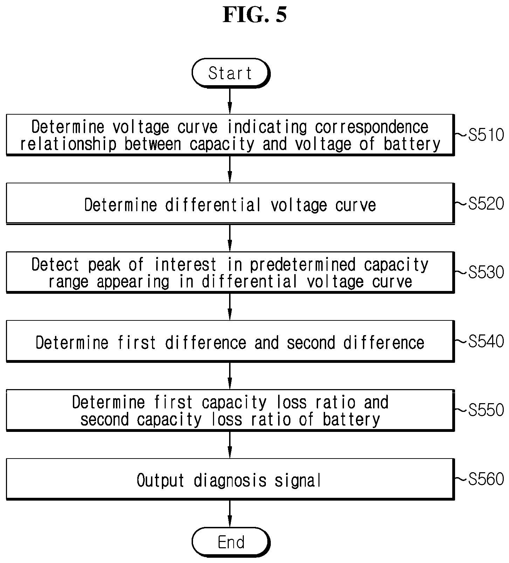

FIG. 5 is a flowchart exemplarily showing a battery management method according to a second embodiment of the present disclosure.

Referring to FIGS. 1 to 3 and 5, in step S510, the control unit 120 determines a voltage curve indicating a correspondence relationship between capacity Q and voltage V of the battery B based on sensing information indicating the voltage and the current of the battery collected from the sensing unit 110 at a predetermined time interval while the battery B is being charged or discharged at the constant current by the charge/discharge device 20.

In step S520, the control unit 120 determines a differential voltage curve based on the voltage curve determined in the step S510. For example, when the voltage curve 204 of FIG. 2 is determined in the step S510, the control unit 120 may determine the differential voltage curve 304 of FIG. 3 from the voltage curve 202.

In step S530, the control unit 120 detects a peak of interest in a predetermined capacity range appearing in the differential voltage curve determined in the step S520. For example, when the differential voltage curve 304 of FIG. 3 is determined in the step S520, the control unit 120 may detect the peak of interest P₄ from the differential voltage curve 304.

In step S540, the control unit 120 determines a first difference and a second difference based on the differential voltage and the capacity of the peak of interest detected in the step S530. The first difference is a difference between the differential voltage of the peak of interest detected in the step S530 and the reference differential voltage. The second difference is a difference between the capacity of the peak of interest detected in the step S530 and the reference capacity. For example, when the peak of interest P₄ of FIG. 3 is detected in the step S530, ΔDVB and ΔQC are determined as the first difference and the second difference, respectively.

In step S550, the control unit 120 determines a first capacity loss ratio and a second capacity loss ratio of the battery B based on the first difference and the second difference. For example, in case that the first difference=ΔDVB and the second difference=ΔQC, the control unit 120 may determine 10% and 10% associated with ΔDVB and ΔQC in the third lookup table as the first capacity loss ratio and the second capacity loss ratio, respectively. The control unit 120 may record the first capacity loss ratio and the second capacity loss ratio determined in the step S550 in the memory unit 130.

In step S560, the control unit 120 outputs a diagnosis signal indicating the first capacity loss ratio and the second capacity loss ratio determined in the step S550. The diagnosis signal may be received by the interface unit 140. The interface unit 140 may transmit the diagnosis signal to the high level controller 2.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the scope of the appended claims.

## Claims

1. A battery management system (100) for a battery (B) comprising a positive electrode material exhibiting a phase transition behavior in a predetermined capacity range and a negative electrode material having plateau characteristics over the predetermined capacity range, the battery management system (100) comprising:
a sensing unit (110) configured to output sensing information indicating a voltage and a current of the battery (B); and
a control unit (120) operably coupled to the sensing unit (110),
wherein the control unit (120) is configured to:
determine a voltage curve indicating a correspondence relationship between a capacity of the battery (B) and the voltage of the battery (B) based on the sensing information collected during constant current charging or constant current discharging of the battery (B),
determine a differential voltage curve based on the voltage curve, the differential voltage curve indicating a correspondence relationship between the capacity of the battery (B) and a differential voltage which is a ratio of a change in the voltage of the battery (B) to a change in the capacity of the battery (B),
detect a peak of interest of the differential voltage curve appearing in the predetermined capacity range, and
determine a first capacity loss ratio indicating a loss ratio of positive electrode capacity of the battery (B) based on a first difference when the differential voltage of the peak of interest is larger than a reference differential voltage, and
wherein the first difference is a difference between the differential voltage of the peak of interest and the reference differential voltage; and
determine a second capacity loss ratio indicating a loss ratio of usable lithium capacity of the battery (B) based on a capacity of the peak of interest when the differential voltage of the peak of interest is equal to the reference differential voltage.

2. The battery management system (100) according to claim 1, wherein the sensing unit (110) includes:
a voltage sensor (111) connected in parallel to the battery (B); and
a current sensor (112) connected in series to the battery (B).

3. The battery management system (100) according to claim 1, wherein the control unit (120) is configured to determine the second capacity loss ratio of the battery (B) based on a second difference when the differential voltage of the peak of interest is equal to the reference differential voltage, and
wherein the second difference is a difference between the capacity of the peak of interest and a reference capacity.

4. The battery management system (100) according to claim 1, wherein the control unit (120) is configured to determine the first capacity loss ratio of the battery (B) and a second capacity loss ratio indicating a loss ratio of usable lithium capacity of the battery (B) based on a first difference and a second difference,
the first difference is a difference between the differential voltage of the peak of interest and the reference differential voltage, and
the second difference is a difference between the capacity of the peak of interest and the reference capacity.

5. A battery pack (10) comprising the battery management system (100) according to any one of claims 1 to 4.

6. An electric vehicle (1) comprising the battery pack (10) according to claim 5.

7. A battery management method for a battery comprising a positive electrode material exhibiting a phase transition behavior in a predetermined capacity range and a negative electrode material having plateau characteristics over the predetermined capacity range, the battery management method comprising:
determining a voltage curve indicating a correspondence relationship between a capacity of the battery and a voltage of the battery based on sensing information indicating the voltage and a current of the battery collected during constant current charging or constant current discharging of the battery;
determining a differential voltage curve based on the voltage curve;
detecting a peak of interest of the differential voltage curve appearing in the predetermined capacity range; and
determining a first capacity loss ratio of the battery (B), indicating a loss ratio of positive electrode capacity of the battery, based on a first difference when the differential voltage of the peak of interest is larger than a reference differential voltage, wherein the first difference is a difference between the differential voltage of the peak of interest and the reference differential voltage; and
determining a second capacity loss ratio indicating a loss ratio of usable lithium capacity of the battery (B) based on a capacity of the peak of interest when the differential voltage of the peak of interest is equal to the reference differential voltage,
wherein the differential voltage curve indicates a correspondence relationship between the capacity of the battery and a differential voltage which is a ratio of a change in the voltage of the battery to a change in the capacity of the battery (B).

## Patentansprüche

1. Batteriemanagementsystem (100) für eine Batterie (B), welche ein Positivelektrodenmaterial, welches in einem vorbestimmten Kapazitätsbereich ein Phasenübergangsverhalten zeigt, und ein Negativelektrodenmaterial umfasst, welches über den vorbestimmten Kapazitätsbereich hinweg Plateau-Eigenschaften aufweist, wobei das Batteriemanagementsystem (100) umfasst:
eine Erfassungseinheit (110), welche dazu eingerichtet ist, Erfassungsinformationen auszugeben, welche eine Spannung und einen Strom der Batterie (B) angeben; und
eine Steuereinheit (120), welche betriebsmäßig mit der Erfassungseinheit (110) gekoppelt ist,
wobei die Steuereinheit (120) eingerichtet ist zum:
Bestimmen einer Spannungskurve, welche eine Korrespondenzbeziehung zwischen einer Kapazität der Batterie (B) und der Spannung der Batterie (B) angibt, auf Grundlage der während eines konstanten Stromladens oder eines konstanten Stromentladens der Batterie (B) gesammelten Erfassungsinformationen,
Bestimmen einer Differenzspannungskurve auf Grundlage der Spannungskurve, wobei die Differenzspannungskurve eine Korrespondenzbeziehung zwischen der Kapazität der Batterie (B) und einer Differenzspannung angibt, welche ein Verhältnis einer Änderung in der Spannung der Batterie (B) zu einer Änderung in der Kapazität der Batterie (B) ist,
Detektieren einer Spitze von Interesse der Differenzspannungskurve, welche in dem vorbestimmten Kapazitätsbereich erscheint, und
Bestimmen eines ersten Kapazitätsverlustverhältnisses, welches ein Verlustverhältnis einer Positivelektrodenkapazität der Batterie (B) angibt, auf Grundlage einer ersten Differenz, wenn die Differenzspannung der Spitze von Interesse größer als eine Referenzdifferenzspannung ist, und
wobei die erste Differenz eine Differenz zwischen der Differenzspannung der Spitze von Interesse und der Referenzdifferenzspannung ist; und
Bestimmen eines zweiten Kapazitätsverlustverhältnisses, welches ein Verlustverhältnis einer nutzbaren Lithiumkapazität der Batterie (B) angibt, auf Grundlage einer Kapazität der Spitze von Interesse, wenn die Differenzspannung der Spitze von Interesse gleich wie die Referenzdifferenzspannung ist.

2. Batteriemanagementsystem (100) nach Anspruch 1, wobei die Erfassungseinheit (110) umfasst:
einen Spannungssensor (111), welcher parallel zu der Batterie (B) geschaltet ist, und
einen Stromsensor (112), welcher in Reihe zu der Batterie (B) geschaltet ist.

3. Batteriemanagementsystem (100) nach Anspruch 1, wobei die Steuereinheit (120) dazu eingerichtet ist, das zweite Kapazitätsverlustverhältnis der Batterie (B) zu bestimmen, auf Grundlage einer zweiten Differenz, wenn die Differenzspannung der Spitze von Interesse gleich wie die Referenzdifferenzspannung ist, und
wobei die zweite Differenz eine Differenz zwischen der Kapazität der Spitze von Interesse und einer Referenzkapazität ist.

4. Batteriemanagementsystem (100) nach Anspruch 1, wobei die Steuereinheit (120) dazu eingerichtet ist, das erste Kapazitätsverlustverhältnis der Batterie (B) und ein zweites Kapazitätsverlustverhältnis zu bestimmen, welches ein Verlustverhältnis einer nutzbaren Lithiumkapazität der Batterie (B) angibt, auf Grundlage einer ersten Differenz und einer zweiten Differenz,
die erste Differenz eine Differenz zwischen der Differenzspannung der Spitze von Interesse und der Referenzdifferenzspannung ist und
die zweite Differenz eine Differenz zwischen der Kapazität der Spitze von Interesse und der Referenzkapazität ist.

5. Batteriepack (10), umfassen das Batteriemanagementsystem (100) nach einem der Ansprüche 1 bis 4.

6. Elektrisches Fahrzeug (1), umfassend den Batteriepack (10) nach Anspruch 5.

7. Batteriemanagementverfahren für eine Batterie, welche ein Positivelektrodenmaterial, welches in einem vorbestimmten Kapazitätsbereich ein Phasenübergangsverhalten zeigt, und ein Negativelektrodenmaterial umfasst, welches über den vorbestimmten Kapazitätsbereich hinweg Plateau-Eigenschaften aufweist, wobei das Batteriemanagementverfahren umfasst:
Bestimmen einer Spannungskurve, welche eine Korrespondenzbeziehung zwischen einer Kapazität der Batterie und einer Spannung der Batterie angibt, auf Grundlage von während eines konstanten Stromladens oder einer konstanten Stromentladens der Batterie gesammelten Erfassungsinformationen, welche die Spannung und einen Strom der Batterie angeben;
Bestimmen einer Differenzspannungskurve auf Grundlage der Spannungskurve;
Detektieren einer Spitze von Interesse der Differenzspannungskurve, welche in dem vorbestimmten Kapazitätsbereich erscheint; und
Bestimmen eines ersten Kapazitätsverlustverhältnisses der Batterie (B), welches ein Verlustverhältnis einer Positivelektrodenkapazität der Batterie angibt, auf Grundlage einer ersten Differenz, wenn die Differenzspannung der Spitze von Interesse größer als eine Referenzdifferenzspannung ist, wobei die erste Differenz eine Differenz zwischen der Differenzspannung der Spitze von Interesse und der Referenzdifferenzspannung ist; und
Bestimmen eines zweiten Kapazitätsverlustverhältnisses, welches ein Verlustverhältnis einer nutzbaren Lithiumkapazität der Batterie (B) angibt, auf Grundlage einer Kapazität der Spitze von Interesse, wenn die Differenzspannung der Spitze von Interesse gleich wie die Referenzdifferenzspannung ist,
wobei die Differenzspannungskurve eine Korrespondenzbeziehung zwischen der Kapazität der Batterie und einer Differenzspannung angibt, welche ein Verhältnis einer Änderung in der Spannung der Batterie zu einer Änderung in der Kapazität der Batterie (B) ist.

## Revendications

1. Système de gestion de batterie (100) pour une batterie (B) comprenant un matériau d'électrode positive présentant un comportement de transition de phase dans une plage de capacité prédéterminée et un matériau d'électrode négative ayant des caractéristiques de plateau sur la plage de capacité prédéterminée, le système de gestion de batterie (100) comprenant :
une unité de détection (110) configurée pour délivrer des informations de détection indiquant une tension et un courant de la batterie (B) ; et
un unité de contrôle (120) couplé de manière fonctionnelle à l'unité de détection (110), dans lequel l'unité de contrôle (120) est configurée pour :
déterminer une courbe de tension indiquant une relation de correspondance entre une capacité de la batterie (B) et la tension de la batterie (B) sur la base des informations de détection collectées lors d'une charge à courant constant ou d'une décharge à courant constant de la batterie (B),
déterminer une courbe de tension différentielle sur la base de la courbe de tension, la courbe de tension différentielle indiquant une relation de correspondance entre la capacité de la batterie (B) et une tension différentielle qui est un rapport d'un changement de la tension de la batterie (B) par rapport à un changement de la capacité de la batterie (B),
détecter un pic d'intérêt de la courbe de tension différentielle apparaissant dans la plage de capacité prédéterminée, et
déterminer un premier rapport de perte de capacité indiquant un rapport de perte de capacité d'électrode positive de la batterie (B) sur la base d'une première différence lorsque la tension différentielle du pic d'intérêt est supérieure à une tension différentielle de référence, et
dans lequel la première différence est une différence entre la tension différentielle du pic d'intérêt et la tension différentielle de référence ; et
déterminer un second rapport de perte de capacité indiquant un rapport de perte de capacité de lithium utilisable de la batterie (B) sur la base d'une capacité du pic d'intérêt lorsque la tension différentielle du pic d'intérêt est égale à la tension différentielle de référence.

2. Système de gestion de batterie (100) selon la revendication 1, dans lequel l'unité de détection (110) comprend :
un capteur de tension (111) connecté en parallèle à la batterie (B) ; et
un capteur de courant (112) connecté en série à la batterie (B).

3. Système de gestion de batterie (100) selon la revendication 1, dans lequel l'unité de contrôle (120) est configurée pour déterminer le second rapport de perte de capacité de la batterie (B) sur la base d'une seconde différence lorsque la tension différentielle du pic d'intérêt est égale à la tension différentielle de référence, et
dans lequel la seconde différence est une différence entre la capacité du pic d'intérêt et une capacité de référence.

4. Système de gestion de batterie (100) selon la revendication 1, dans lequel l'unité de contrôle (120) est configurée pour déterminer le premier rapport de perte de capacité de la batterie (B) et un second rapport de perte de capacité indiquant un rapport de perte de capacité de lithium utilisable de la batterie (B) sur la base d'une première différence et d'une seconde différence,
la première différence est une différence entre la tension différentielle du pic d'intérêt et la tension différentielle de référence ; et
la seconde différence est une différence entre la capacité du pic d'intérêt et la capacité de référence.

5. Bloc-batterie (10) comprenant le système de gestion de batterie (100) selon l'une quelconque des revendications 1 à 4.

6. Véhicule électrique (1) comprenant le bloc-batterie (10) selon la revendication 5.

7. Procédé de gestion de batterie pour une batterie comprenant un matériau d'électrode positive présentant un comportement de transition de phase dans une plage de capacité prédéterminée et un matériau d'électrode négative ayant des caractéristiques de plateau sur la plage de capacité prédéterminée, le procédé de gestion de batterie comprenant :
la détermination d'une courbe de tension indiquant une relation de correspondance entre une capacité de la batterie et une tension de la batterie sur la base d'informations de détection indiquant la tension et un courant de la batterie collectés lors d'une charge à courant constant ou d'une décharge à courant constant de la batterie ;
la détermination d'une courbe de tension différentielle sur la base de la courbe de tension ;
la détection d'un pic d'intérêt de la courbe de tension différentielle apparaissant dans la plage de capacité prédéterminée ; et
la détermination d'un premier rapport de perte de capacité de la batterie (B), indiquant un rapport de perte de capacité d'électrode positive de la batterie, sur la base d'une première différence lorsque la tension différentielle du pic d'intérêt est supérieure à une tension différentielle de référence, dans lequel la première différence est une différence entre la tension différentielle du pic d'intérêt et la tension différentielle de référence ; et
la détermination d'un second rapport de perte de capacité indiquant un rapport de perte de capacité de lithium utilisable de la batterie (B) sur la base d'une capacité du pic d'intérêt lorsque la tension différentielle du pic d'intérêt est égale à la tension différentielle de référence,
dans lequel la courbe de tension différentielle indique une relation de correspondance entre la capacité de la batterie et une tension différentielle qui est un rapport d'un changement de la tension de la batterie par rapport à un changement de la capacité de la batterie (B).
